# EUROPEAN PATENT SPECIFICATION

(11) **EP 0 532 087 B1**
(45) Date of publication and mention of the grant of the patent: **09.07.1997**
(21) Application number: 92202654.7
(22) Date of filing: 02.09.1992
(51) Int. Cl.: G11C 29/00

(54) **Process for checking the memories of a programmed micro-computer, by means of a micro-programme incorporated in the micro-computer itself**
Verfahren zum Prüfen von Speichern eines programmierten Mikrorechners mittels eines im besagten Mikrorechner eingebauten Mikroprogramms
Procédé de vérification de mémoires d'un microordinateur programmé au moyen d'un microprogramme incorporé dans le microordinateur lui même

(30) Priority: 10.09.1991 IT MI912385
(43) Date of publication of application: 17.03.1993
(73) Proprietor: SGS-THOMSON MICROELECTRONICS s.r.l., 20041 Agrate Brianza (Milano) (IT)
(72) Inventor: Scarra, Flavio, I-20041 Agrate Brianza (Milano) (IT)
(74) Representative: Mittler, Enrico

(56) References cited:
- EP-A- 0 315 275
- US-A- 4 744 049
- IRE WESCON CONVENTION RECORD vol. 34, November 1990, NORTH HOLLYWOOD US pages 175 - 178 , XP227867 GALLAKOTA ET AL 'Testing of the i486 microprocessor'
- PATENT ABSTRACTS OF JAPAN vol. 7, no. 23 (P-171)(1168) 29 January 1983 & JP-A-57 176 600
- PATENT ABSTRACTS OF JAPAN vol. 8, no. 248 (P-313)(1685) 14 November 1984 & JP-A-59 119 595

## Description

The present invention relates to a process for checking the memories of a programmed micro-computer, optimized as regards life and efficiency.

In the production of micro-computers the finished products are subjected to testing operations, in order to check on their functionality.

Generally micro-computers have memories within them of not inconsiderable size, and considering that the checking time depends, in addition to the size of the memory, also on the type of memory to be checked, and that a minimum of three readings is required for a ROM (READ ONLY MEMORY) and a maximum of sixteen readings for an EPROM (ERASABLE READ ONLY MEMORY), it can be seen that checking operations involve problems of time and cost, especially because they are executed on very expensive machines.

With the current checking devices and procedures, based on programmes formed by instructions, that require a discrete time for the process of reading any information contained in the memory, testing times are very long and involve substantial increases in production costs.

IRE WESCON CONVENTION RECORD, vol. 34, Nov. 1990, North Hollywood, USA, p. 175-178, GALLAKOTA et al.:" Testing of the i486 microprocessor" discloses a built-in self test on a microprocessor wherein microcode controls the testing of a cache. EP-A-0 315 275 discloses testing of a microcomputer memory using scan patch circuitry for addressing the memory and for data input/output.

The object of the present invention is a process for checking the memories of a micro-computer, that allows an improvement in the analysis of said memories, at the same time minimizing checking times, so as to reduce production costs.

According to this object a process has been developed for checking the memories of a programmed micro-computer, the micro-computer comprising:
read only memories and read-and-write memories, divided into logic spaces suitable for containing information related to programmes and data,
a group of input and output gates,
a register file,
a central micro-processor unit (CPU) comprising in turn
a control memory containing micro-programmes constituted by micro-instructions,
a pre-processor suitable for decoding instruction codes and for defining the addresses of the input points of the micro-programmes related to the instructions,
a circuit for decoding said addresses of the input points of the micro-programmes,
a pointer capable of addressing said micro-instructions of said micro-programmes,
two scanning cell chains suitable for being triggered by means of pre-established operating signals and capable of providing control signals of said logic spaces of said memories and of said micro-programmes,
a decoding unit capable of transforming into operational signals said micro-instructions of the micro-programmes contained in said control memory,
an arithmetic-logic unit containing an indicator register,
a programme counter and incrementer, capable of controlling the process of addressing the information contained in said read-only and read-and-write memories,
a circuit capable of providing the address of each pre-selected register of said register file,
the above process being characterized in that it comprises the following steps:
to trigger said scanning cell chains by means of pre-established operating signals to generate control signals indicative of the pre-selected logic space of one of said memories to be checked, according to a pre-selected checking procedure that can be executed by means of micro-instructions of a suitable micro-programme stored in said control memory,
to select, through said scanning cell chains, said pre-selected logic space to be checked,
to initialize, through said scanning cell chains, said programme counter and incrementer, to define the starting point of said pre-selected logic space to be checked,
to select, through said scanning cell chains, one of the registers of said file and one of said gates, as an output gate, on which to send all information taken from said logic space,
to trigger, through said scanning cell chains, said control memory, said pre-processor, said decoding unit and said pointer for addressing said micro-instructions of the micro-programme related to said pre-selected checking procedure, in order that it be executed by means of a pre-established number of clock strokes,
to send to said selected register of said register file and to said output gate an information taken from said pre-selected logic space,
to repeat in a loop, according to an incremental sequence, the execution of said micro-instructions of the micro-programme so as to send in succession to said selected register of said register file and to said output gate all the information contained in said pre-selected logic space, and
to reset the micro-controller through a special signal to return it to normal operating conditions.

According to a preferred embodiment, said micro-programme suitable for executing a pre-selected checking procedure is a micro-programme formed by groups of micro-instructions for executing a procedure for reading said memories.

According to another preferred embodiment, said micro-programme suitable for executing a pre-selected checking procedure is a micro-programme formed by groups of micro-instructions to execute a process of writing during the testing step, of said memories.

With the checking process according to the invention, based on micro-programmes and on an infinite loop micro-procedure, it is possible to proceed to an incremental reading, or writing, of the memories of a micro-controller, analysing all the information contained in them, in a very short time.

The process according to the invention is particularly advantageous because it is based on micro-programmes incorporated in the micro-computer and of a general-purpose type, that may be used on any micro-computer of the same family without any changes and with no specific adaptations.

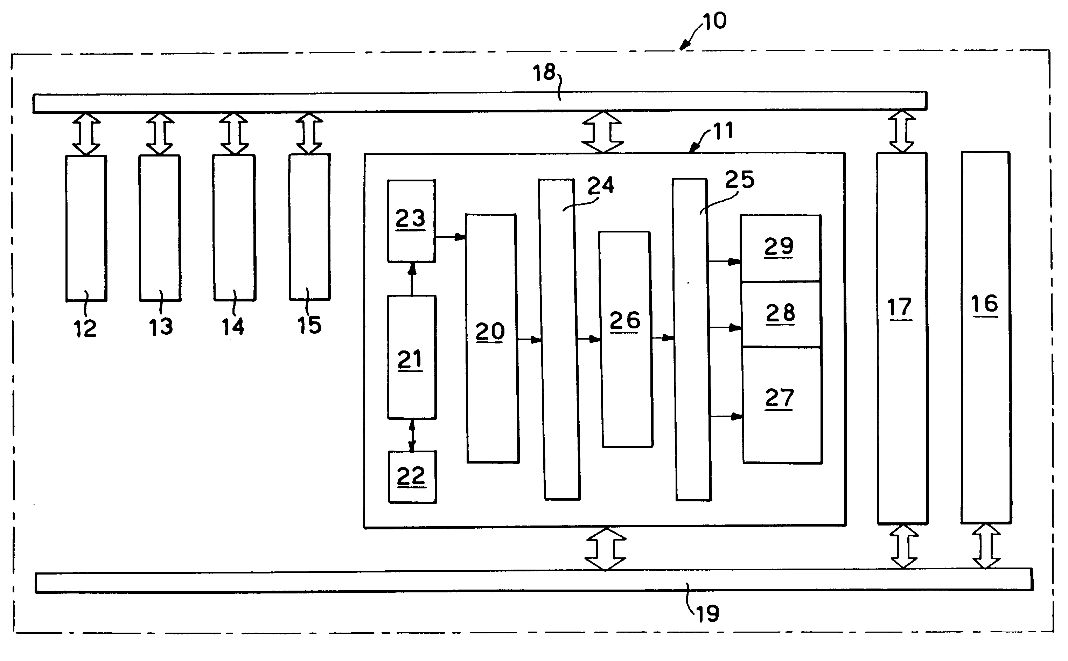

Features and advantages of the invention shall now be illustrated with reference to a preferred embodiment, represented as non-limiting examples in the enclosed drawing, wherein:
the only figure illustrates, with a block diagramme, a micro-processor that incorporates micro-programmes suitable for executing the checking process according to the invention.

There is indicated in the figure as a whole with 10 a micro-controller comprising a central micro-processor unit (CPU), indicated as a whole with 11, a reading and writing memory (RAM) 12, an electrically-erasable programmable read-only memory (EEPROM) 13, an erasable programmable read-only memory (EPROM) 14, a read-only memory (ROM) 15, a group of input and output gates 16, a register file 17, a bus 18 operationally connected to the memmories 12-15 and to the central micro-processor unit 11, and a bus 19 operationally connected to the same central micro-processor unit, to the group of input and output gates 16 and to the register file 17.

The central micro-processor unit 11 in turn comprises a read-only control memory (CROM) indicated with 20, a pre-processor indicated with 21, a decoding circuit indicated with 22, a pointer indicated with 23, two scanning cell chains indicated with 24 and 25, a decoding unit indicated with 26, an arithmetic-logic unit (ALU) 27 containing an indicator register (flag), a programme counter and incrementer indicated with 28, a circuit for the process of addressing the registers of the file 17, indicated with 29, all connected operationally together.

The control memory 20 is suitable for containing micro-programmes constituted by micro-instructions, which, according to the invention, are micro-programmes formed by micro-instructions suitable for executing the checking procedures, such as the process of reading of memories 12-15, and the process of writing during the testing step of memories 14 and 15.

The pre-processor 21 contains registers of instructions with the addresses of the input points of said micro-programmes, and the decoding circuit 22 executes the decoding of said addresses of the input points of the same micro-programmes; the pointer 23 is capable of addressing said micro-instructions of said micro-programmes.

The two scanning cell chains 24 and 25 are suitable for being triggered by means of pre-established operating signals, that are introduced into the micro-processor 11 through a reset gate of the group 16, and are capable of supplying the control signals of the logic spaces of said read-only, and read-and-write, memories and of said micro-programmes.

The decoding unit 26 is capable of transforming into operational signals said micro-instructions of the micro-programmes contained in the control memory 20.

The arithmetic-logic unit 27 contains an indicator register (flag), suitable for identifying the logic space selected by one of said memories 12-15.

The programme counter and incrementer 28 is capable of controlling the process of addressing the information contained in said read-only and read-and-write memories.

As has already been said, the control memory 20 contains micro-programmes suitable for executing procedures for checking, reading or writing the memories.

The micro-programme for executing the procedure for reading is formed by the following sequence of micro-instructions:
a first micro-instruction suitable for starting the reading operation: u1) START READ (next u2),
a second micro-instruction to prepare the process of addressing the subsequent information to be read, in a buffer register (master latch) of the selected memory: u2) INC+ ->PC & LIP, R* (next u3),
a third micro-instruction suitable for writing the information read in a pre-selected register of the file 17 and in a pre-selected gate of the group 16, and to recharge the incrementer 28 with the address of the subsequent information to be read: u3) MEM -> DWR PC -> INC SET INC (next u1).

The micro-programme for executing the procedure for writing information identical with pre-selected addresses is formed by the following sequence of micro-instructions:
a first micro-instruction suitable for starting the operation of writing an information identical with the low part of an address: u1) START WRITE PC1 ->LIP, RO (next 2),
a second micro-instruction to prepare the process of addressing the subsequent information to be written, in a buffer register of the selected memory: u2) INC+ ->PC & LIP, R* (next u3),
a third micro-instruction suitable for recharging the incrementer 28 with the address of the subsequent information to be written: PC ->INC SET INC (next u1).

The micro-programme for executing the matrix-type writing procedure of information identical with that contained in two pre-selected registers (AD and AB) of the group 16, is formed by the following sequence of micro-instructions:
a first micro-instruction suitable for starting the operation of writing an information identical with that contained in the first pre-selected register (AD): u1) START WRITE AD ->LIP, RO (next 2),
a second micro-instruction to prepare the process of addressing the subsequent information to be written, in a buffer register of the selected memory: u2) INC+ ->PC & LIP, R∗ (next u3),
a third micro-instruction suitable for recharging the incrementer 28 with the address of the subsequent information to be written: PC ->INC SET INC (next u4),
a fourth micro-instruction suitable for starting the operation of writing an information identical with that contained in the second pre-selected register (AB): u4) START WRITE AB ->LIP, RO (next u5),
a fifth micro-instruction to prepare the process of addressing the subsequent information to be written, in a buffer register of the selected memory: u5) INC+ ->PC & LIP, R∗ (next u6),
a sixth micro-instruction suitable for recharging the incrementer 28 with the address of the subsequent information to be written: PC ->INC SET INC (next u1).

To execute the process of checking the memories 12-15, by means of the reading procedure or by means of the reading and writing procedure, pre-established operating signals are introduced through said reset gate of the group 16; these operating signals, that, for example, consist of two pre-selected voltage levels, 7.5 volts and 5 volts, sent in a given sequence, generate control signals that interrupt the normal operation of the micro-controller and trigger the scanning cell chains 24 and 25; these, with a "scan path" procedure, described in the Italian patent application No. 21820 A/90 (IT-B-1246301), in the name of the same Applicant, select the pre-selected logic space of one of the memories 12-15 to be checked, containing either programme information or data information; the same scanning cell chains select the starting point of the same logic space, set the programme counter 28 with the information identifying the same starting point, and selects one of the gates of the group 16, configuring it as the output gate of the information taken from the selected logic space, so that these are transferred into a pre-selected register of the file 17 and at the same time on said output gate.

The same scanning cell chains 24 and 25 trigger the address of the input point of one of the micro-programmes for checking, reading or writing, stored in the control memory 20, through the pre-processor 21, the decoding unit 22 and the pointer 23.

Control of the reading and writing micro-programmes is executed through the number of clock strokes necessary for the entire operation to be completed, taking into account that each set of micro-instructions of the same micro-programmes requires one clock stroke and that three clock strokes are necessary for reading an information, while from three to six clock strokes are necessary for writing an information.

The checking process is executed with an infinite-loop micro-procedure, which in the minimum access time for internal memories, three clock strokes, executes an incremental reading, or writing, with the information returned on the selected output gate of the group 16.

To exit from the checking procedure reset the micro-controller 10.

The checking process described, based on micro-programmes and on an infinite-loop micro-procedure, allows the execution of the reading and writing process of the memories of a micro-controller, in a complete manner, analysing all the information contained in them, with a substantial time saving over the usual procedures, based on programmes formed by instructions, that, for the process of reading an information contained in the memory, typically require ten clock strokes.

Another advantage of the proposed procedure is that of being based on micro-programmes incorporated in the micro-computer and of the general-purpose type, that may be used on any micro-computer without any changes and with no specific adaptations.

## Claims

1. Process for checking the memories of a programmed micro-computer (10), the micro-computer (10) comprising:
read only memories and read-and-write memories (12, 13, 14, 15), divided into logic spaces suitable for containing information related to programmes and data,
a group of input and output gates (16),
a register file (17),
a central micro-processor unit (CPU) (11) comprising in turn
a control memory (20) containing micro-programmes constituted by micro-instructions,
a pre-processor (21) suitable for decoding instruction codes and for defining the addresses of the input points of the micro-programmes related to the instructions,
a circuit (22) for decoding said addresses of the input points of the micro-programmes,
a pointer (23) capable of addressing said micro-instructions of said micro-programmes,
two scanning cell chains (24, 25) suitable for being triggered by means of pre-established operating signals and capable of providing control signals of said logic spaces of said memories (12-15) and of said micro-programmes,
a decoding unit (26) capable of transforming into operational signals said micro-instructions of the micro-programmes contained in said control memory,
an arithmetic-logic unit (27) containing an indicator register,
a programme counter and incrementer (28) capable of controlling the process of addressing the information contained in said read-only and read-and-write memories,
a circuit (29) capable of providing the address of each pre-selected register of said register file,
the above process being characterized in that it comprises the following steps:
to trigger said scanning cell chains (24, 25) by means of pre-established operating signals to generate control signals indicative of the pre-selected logic space of one of said memories (12-15) to be checked, according to a pre-selected checking procedure that can be executed by means of micro-instructions of a suitable micro-programme stored in said control memory (20),
to select, through said scanning cell chains (24, 25), said pre-selected logic space to be checked,
to initialize, through said scanning cell chains, (24, 25), said programme counter and incrementer (28), to define the starting point of said pre-selected logic space to be checked,
to select, through said scanning cell chains (24, 25), one of the registers of said file (17) and one of said gates (16), as an output gate, on which to send all information taken from said logic space,
to trigger, through said scanning cell chains (24, 25), said control memory (20), said pre-processor (21), said decoding unit (22) and said pointer (23) for addressing said micro-instructions of the micro-programme related to said pre-selected checking procedure, in order that it be executed by means of a pre-established number of clock strokes,
to send to said selected register of said register file (17) and to said output gate (16), an information taken from said pre-selected logic space,
to repeat in a loop, according to an incremental sequence, the execution of said micro-instructions of the micro-programme so as to send in succession to said selected register of said register file (17) and to said output gate all the information contained in said pre-selected logic space, and
to reset the micro-computer (10) through a special signal to return it to normal operating conditions.

2. Process according to claim 1, characterised in that said micro-programme suitable for executing a pre-selected checking procedure is a micro-programme formed by a sequence of micro-instructions for executing a procedure for reading said memories (12, 13, 14, 15).

3. Process according to claim 1, characterised in that said micro-programme suitable for executing a pre-selected checking procedure is a micro-programme formed by a sequence of micro-instructions for executing a process of writing during the testing step, of pre-established information in said memories (12, 13).

4. Process according to claim 2, characterised in that said micro-programme for executing the procedure for reading is formed by the following sequence of micro-instructions:
a first micro-instruction suitable for starting the reading operation,
a second micro-instruction to prepare the process of addressing the subsequent information to be read, in a buffer register (master latch) of the selected memory (14, 15),
a third micro-instruction suitable for writing the information read in a pre-selected register of said register file (17) and in the pre-selected gate of said output gates (16), and to recharge said programme counter and incrementer (28) with the address of the subsequent information to be read.

5. Process according to claim 3, characterised in that said micro-programme for executing the procedure for writing, particularly in the case of information identical with pre-selected addresses, is formed by the following sequence of micro-instructions:
a first micro-instruction suitable for starting the operation of writing an information identical with the low part of an address,
a second micro-instruction to prepare the process of addressing the subsequent information to be written, in a buffer register of the selected memory (12, 13),
a third micro-instruction suitable for recharging said incrementer (28) with the address of the subsequent information to be written.

6. Process according to claim 3, characterised in that said micro-programme for executing the writing procedure, particularly matrix-type writing of information identical with that contained in two pre-selected registers (AD and AB) of said output gates (16), is formed by the following sequence of micro-instructions:
a first micro-instruction suitable for starting the operation of writing an information identical with that contained in the first pre-selected register (AD),
a second micro-instruction to prepare the process of addressing the subsequent information to be written, in a buffer register of the selected memory (12, 13),
a third micro-instruction suitable for recharging said programme counter and incrementer (28) with the address of the subsequent information to be written,
a fourth micro-instruction suitable for starting the operation of writing an information identical with that contained in the second pre-selected register (AB),
a fifth micro-instruction to prepare the process of addressing the subsequent information to be written, in a buffer register of the selected memory (12, 13),
a sixth micro-instruction suitable for recharging said programme counter and incrementer (28) with the address of the subsequent information to be written.

## Patentansprüche

1. Verfahren zum Prüfen der Speicher eines programmierten Mikrocomputers (10), welcher aufweist:
Nur-Lese-Speicher und Schreib-/Lese-Speicher (12, 13, 14, 15), die in logische Speicherräume unterteilt sind, welche Information bezüglich Programmen und Daten enthalten,
eine Gruppe von Eingabe- und Ausgabegattern (16),
einen Registersatz (17),
eine zentrale Mikroprozessoreinheit (CPU) (11), die ihrerseits enthält:
einen Steuerspeicher (20), der durch Mikrobefehle gebildete Mikroprogramme enthält,
einen Vorprozessor (21) zum Dekodieren von Befehlscodes und zum Definieren der Adressen der Eingangspunkte der sich auf die Befehle beziehenden Mikroprogramme,
eine Schaltung (22) zum Dekodieren der Adressen der Eingangspunkte der Mikroprogramme,
einen Zeiger (23) zum Adressieren der Mikrobefehle der Mikroprogramme,
zwei Abtastzellenketten (24, 25), die mittels vorab eingerichteter Operationssignale getriggert werden und Steuersignale der logischen Speicherräume der Speicher (12-15) und der Mikroprogramme bereitstellen können,
eine Dekodiereinheit (26), die in der Lage ist, die Mikrobefehle der Mikroprogramme, die in dem Steuerspeicher enthalten sind, in Operationssignale umzusetzen,
eine arithmetisch-logische Einheit (27), die ein Indikatorregister enthält,
einen Programmzähler/Inkrementierer (28) zum Steuern des Vorgangs der Adressierung der Information, die in den Nur-Lese- und Schreib-/Lese-Speichern enthalten ist,
eine Schaltung (29) zum Bereitstellen der Adresse jedes vorab ausgewählten Registers des Registersatzes,
wobei das Verfahren durch folgende Schritte gekennzeichnet ist:
die Abtastzellenketten (24, 25) werden mittels vorab eingerichteter Operationssignale getriggert, um Steuersignale zu generieren, die den vorab ausgewählten logischen Speicherraum eines der zu prüfenden Speicher (12-15) bezeichnen, und zwar nach Maßgabe einer vorab ausgewählten Prüfprozedur, die mit Hilfe von Mikrobefehlen eines geeigneten Mikroprogramms ausgeführt wird, welches in dem Steuerspeicher (20) gespeichert ist,
über die Abtastzellenketten (24, 25) wird der zu prüfende, vorab ausgewählte logische Speicherraum ausgewählt,
über die Abtastzellenketten (24, 25) wird der Programmzähler/Inkrementierer (28) initialisiert, um den Anfangspunkt des zu prüfenden, vorab ausgewählten logischen Speicherraums zu definieren,
über die Abtastzellenketten (24, 25) wird eines der Register des Registersatzes (17) und eines der Gatter (16) als ein Ausgangsgatter ausgewählt, zu dem sämtliche aus dem logischen Speicherraum kommende Information gesendet wird,
über die Abtastzellenketten (24, 25), den Steuerspeicher (20), den Vorprozessor (21), die Dekodiereinheit (22) und den Zeiger (23) wird das Adressieren der Mikrobefehle des Mikroprogramms bezüglich der vorab ausgewählten Prüfprozedur ausgelöst, damit diese durch eine vorbestimmte Anzahl von Taktimpulsen ausgeführt wird,
an das ausgewählte Register des Registersatzes (17) und an das Ausgangsgatter (16) wird eine Information gesendet, die aus dem vorab ausgewählten logischen Speicherraum entnommen wurde,
entsprechend einer inkrementellen Sequenz wird als Schleife die Ausführung der Mikrobefehle des Mikroprogramms wiederholt, um in Folge an das ausgewählte Register des Registersatzes (17) und das Ausgangsgatter sämtliche Information zu senden, die in dem vorab ausgewählten logischen Speicherraum enthalten ist, und
der Mikrocomputer (10) wird durch ein spezielles Signal zurückgesetzt, um in den normalen Betriebszustand zurückzukehren.

2. Verfahren nach Anspruch 1,
**dadurch gekennzeichnet**, daß das zur Ausführung einer vorab ausgewählten Prüfprozedur geeignete Mikroprogramm ein Mikroprogramm ist, welches gebildet wird durch eine Sequenz von Mikrobefehlen zum Ausführen einer Prozedur zum Lesen der Speicher (12, 13, 14, 15).

3. Verfahren nach Anspruch 1,
**dadurch gekennzeichnet**, daß das zur Ausführung einer vorab ausgewählten Prüfprozedur geeignete Mikroprogramm ein Mikroprogramm ist, welches gebildet wird durch eine Sequenz von Mikrobefehlen zum Ausführung eines Prozesses, bei dem während des Prüfschritts eine vorab eingerichtete Information in die Speicher (12, 13) eingeschrieben wird.

4. Verfahren nach Anspruch 2,
**dadurch gekennzeichnet,** daß das Mikroprogramm zur Ausführung der Prozedur zum Lesen gebildet wird durch folgende Mikrobefehls-Sequenz:
einen ersten Mikrobefehl, geeignet, um die Leseoperation zu starten;
einen zweiten Mikrobefehl zum Vorbereiten des Prozesses der Adressierung der als nächstes zu lesenden Information in einem Pufferregister (Haupt-Zwischenspeicher) des ausgewählten Speichers (14, 15);
einen dritten Mikrobefehl, geeignet, um die gelesene Information in einem vorab ausgewählten Register des Registersatzes (12) und in dem vorab ausgewählten Gatter der Ausgangsgatter (16) einzuschreiben und den Programmzähler/Inkrementierer (28) erneut mit der Adresse der als nächstes zu lesenden Information zu laden.

5. Prozeß nach Anspruch 3,
**dadurch gekennzeichnet**, daß das Mikroprogramm zum Ausführen der Schreibprozedur, insbesondere im Fall von Information, die mit vorab ausgewählten Adressen identisch ist, durch folgende Mikrobefehls-Sequenz gebildet wird:
einen ersten Mikrobefehl, geeignet, um die Schreiboperation einer Information zu starten, die identisch ist mit dem unteren Teil einer Adresse;
einen zweiten Mikrobefehl zum Vorbereiten des Prozesses der Adressierung der als nächstes zu schreibenden Information in einem Pufferregister des ausgewählten Speichers (12, 13); und
einen dritten Mikrobefehl, geeignet zum erneuten Laden des Inkrementierers (28) mit der Adresse der als nächstes zu schreibenden Information.

6. Verfahren nach Anspruch 3,
**dadurch gekennzeichnet,** daß das Mikroprogramm zur Ausführung der Schreibprozedur, insbesondere des Matrix-Schreibens von Information, die identisch mit derjenigen ist, die in den zwei vorab ausgewählten Registern (AD und AB) der Ausgangsgatter (16) enthalten ist, durch folgende Mikrobefehls-Sequenz gebildet wird:
einen ersten Mikrobefehl, geeignet zum Starten der Schreiboperation einer Information identisch mit derjenigen, die in dem ersten vorab ausgewählten Register (AD) enthalten ist;
einen zweiten Mikrobefehl zum Vorbereiten des Prozesses der Adressierung der als nächstes zu schreibenden Information in einem Pufferregister des ausgewählten Speichers (12, 13),
einen dritten Mikrobefehl, geeignet zum erneuten Laden des Programmzählers/Inkrementierers (28) mit der Adresse der als nächstes zu schreibenden Information,
einen vierten Mikrobefehl, geeignet zum Starten der Schreiboperation einer Information identisch mit derjenigen, die in dem zweiten vorab ausgewählten Register (AB) enthalten ist,
einen fünften Mikrobefehl zum Vorbereiten des Prozesses der Adressierung der als nächstes zu schreibenden Information in einem Pufferregister des ausgewählten Speichers (12, 13), und
einen sechsten Mikrobefehl, geeignet zum erneuten Laden des Programmzählers/Inkrementierers (28) mit der Adresse der als nächstes zu schreibenden Information.

## Revendications

1. Procédé de vérification des mémoires d'un micro-ordinateur programmé (10), le micro-ordinateur (10) comprenant :
des mémoires mortes et des mémoires à lecture/écriture (12, 13, 14, 15) divisées en espaces logiques propres à contenir des informations liées à des programmes et à des données,
un groupe de portes d'entrée et de sortie (16),
des registres de travail (17),
une unité centrale (CPU) (11) contenant une mémoire de commande (20) qui contient des microprogrammes constitués de micro-instructions,
un pré-processeur (21) propre à décoder des codes d'instructions et à définir les adresses des points d'entrée des microprogrammes liés aux instructions,
un circuit (22) pour décoder lesdites adresses des points d'entrée des microprogrammes,
un pointeur (23) propre à adresser les micro-instructions des microprogrammes,
deux chaînes de cellules d'analyse (24, 25) propres à être déclenchées par des signaux d'actionnement préétablis et propres à fournir des signaux de commande des espaces logiques des mémoires (12, 15) et des microprogrammes,
un module de décodage (26) propre à transformer en signaux opérationnels les micro-instructions des microprogrammes contenus dans la mémoire de commande,
une unité arithmétique et logique (27) contenant un registre indicateur,
un dispositif de comptage et d'incrémentation de programme (28) capable de commander le processus d'adressage des informations contenues dans les mémoires mortes et à lecture/ écriture,
un circuit (29) propre à fournir l'adresse de chaque registre de travail présélectionné,
le procédé ci-dessus étant caractérisé en ce qu'il comprend les étapes suivantes :
déclencher les chaînes de cellules d'analyse (24, 25) par des signaux d'actionnement préétablis pour produire des signaux de commande indicatifs de l'espace logique présélectionné de l'une des mémoires (12-15) à vérifier, selon une procédure de vérification présélectionnée qui peut être exécutée par des micro-instructions d'un microprogramme convenable stocké dans la mémoire de commande (20),
sélectionner par l'intermédiaire des chaînes de cellules d'analyse (24, 25) l'espace logique présélectionné à vérifier,
initialiser, par l'intermédiaire des chaînes de cellules d'analyse (24, 25), le dispositif de comptage et d'incrémentation de programme (28) pour définir le point de départ de l'espace logique présélectionné à vérifier,
sélectionner par l'intermédiaire des chaînes de cellules d'analyse (24, 25) l'un des registres de travail (17) et l'une des portes (16) en tant que porte de sortie sur laquelle envoyer toutes les informations prises à partir de l'espace logique,
déclencher, par l'intermédiaire des chaînes de cellules d'analyse (24, 25) la mémoire de commande (20), le pré-processeur (21), le module de décodage (22) et le pointeur (23) pour adresser les micro-instructions du microprogramme concerné par la procédure de vérification présélectionnée, de sorte qu'elle soit exécutée par un nombre préétabli de coups d'horloge,
envoyer au registre sélectionné des registres de travail (17) et à la porte de sortie (16) une information prise à partir de l'espace logique présélectionné,
répéter selon une boucle, selon une séquence incrémentielle, l'exécution des micro-instructions du microprogramme de façon à envoyer successivement au registre sélectionné desdits registres de travail (17) et à la porte de sortie toutes les informations contenues dans l'espace logique présélectionné, et
remettre à zéro le micro-ordinateur (10) par l'intermédiaire d'un signal spécial pour le ramener à des conditions de fonctionnement normal.

2. Procédé selon la revendication 1, caractérisé en ce que le microprogramme propre à exécuter une procédure de vérification présélectionnée est un microprogramme constitué d'une séquence de micro-instructions pour exécuter une procédure pour lire les mémoires (12, 13, 14, 15).

3. Procédé selon la revendication 1, caractérisé en ce que le microprogramme propre à exécuter une procédure de vérification présélectionnée est un microprogramme constitué d'une séquence de micro-instructions pour exécuter un processus d'écriture pendant l'étape de test d'informations préétablies dans les mémoires (12, 13).

4. Procédé selon la revendication 2, caractérisé en ce que le microprogramme pour exécuter la procédure de lecture est constitué de la séquence de micro-instructions suivante :
une première micro-instruction propre à faire démarrer l'opération de lecture,
une deuxième micro-instruction pour préparer le processus d'adressage des informations suivantes à lire, dans un registre tampon (bascule maître) de la mémoire choisie (14, 15),
une troisième micro-instruction propre à écrire les informations lues dans un registre présélectionné des registres de travail (17) et dans la porte présélectionnée des portes de sortie (16), et pour recharger le dispositif de comptage et d'incrémentation de programme (28) par l'adresse de l'information suivante à lire.

5. Procédé selon la revendication 3, caractérisé en ce que le microprogramme pour exécuter la procédure d'écriture, en particulier dans le cas d'informations identiques aux adresses présélectionnées, est constitué de la séquence de micro-instructions suivante :
une première micro-instruction propre à faire démarrer l'opération d'écriture d'une information identique à la partie inférieure d'une adresse,
une deuxième micro-instruction pour préparer le processus d'adressage des informations suivantes à écrire, dans un registre tampon de la mémoire choisie (12, 13),
une troisième micro-instruction propre à recharger le dispositif d'incrémentation (28) par l'adresse des informations suivantes à écrire.

6. Procédé selon la revendication 3, caractérisé en ce que le microprogramme pour exécuter la procédure d'écriture, en particulier l'écriture de type matriciel d'informations identiques à celles contenues dans les deux registres présélectionnés (AD et AB) des portes de sortie (16), est constitué de la séquence de micro-instructions suivante :
une première micro-instruction propre à faire démarrer l'opération d'écriture d'une information identique à celle contenue dans le premier registre présélectionné (AD),
une deuxième micro-instruction pour préparer le procédé d'adressage des informations suivantes à écrire dans un registre tampon de la mémoire choisie (12, 13),
une troisième micro-instruction propre à recharger le dispositif de comptage et d'incrémentation de programme (28) par l'adresse de l'information suivante à écrire,
une quatrième micro-instruction propre à faire démarrer l'opération d'écriture d'une information identique à celle contenue dans le deuxième registre présélectionné (AB),
une cinquième micro-instruction pour préparer le processus d'adressage de l'information suivante à écrire, dans un registre tampon de la mémoire choisie (12, 13),
une sixième micro-instruction propre à recharger le dispositif de comptage et d'incrémentation de programme (28) par l'adresse de l'information suivante à écrire.
